# EUROPÄISCHE PATENTSCHRIFT

(11) **EP 0 390 004 B1**
(45) Veröffentlichungstag und Bekanntmachung des Hinweises auf die Patenterteilung: **08.11.1995**
(21) Anmeldenummer: 90105666.3
(22) Anmeldetag: 26.03.1990
(51) Int. Cl.: H01J 37/32, H05H 1/46

(54) **Verfahren und Vorrichtung zum Mikrowellen-Plasmaätzen**
Method and device for the microwave-plasma etching
Procédé et dispositif pour la gravure par plasma micro-onde

(30) Priorität: 27.03.1989 JP 74316/89
(43) Veröffentlichungstag der Anmeldung: 03.10.1990
(73) Patentinhaber: ANELVA CORPORATION, Fuchu-shi Tokyo 183 (JP); NEC CORPORATION, Minato-ku Tokyo (JP)
(72) Erfinder: Samukawa, Seiji c/o NEC Corporation, Minato-ku, Tokyo (JP); Sasaki, Masami c/o Anelva Corp., Fuchi-shi, Tokyo (JP); Mori, Sumio c/o Anelva Corp., Fuchi-shi, Tokyo (JP)
(74) Vertreter: Freiherr von Schorlemer, Reinfried, Dipl.-Phys.

(56) Entgegenhaltungen:
- EP-A- 0 279 895
- EP-A- 0 284 436
- EP-A- 0 290 036

## Beschreibung

Die Erfindung betrifft Verfahren und Vorrichtungen zum Mikrowellen-Plasmaätzen, insbesondere für die Anwendung bei der Herstellung von Halbleitern, Halbleitervorrichtungen und anderen, ähnlichen elektrischen Vorrichtungen. Dabei kann die Plasmaätz-Vorrichtung z.B. zum Ätzen der Oberfläche eines Trägermaterials bzw. Substrats, zur Bildung oder Abscheidung dünner Filme auf der Substrat-Oberfläche und für andere Arten von Oberflächenbearbeitungen verwendet werden, bei denen ein durch Elektron/Zyklotron-Resonanz erzeugtes Plasma benutzt wird.

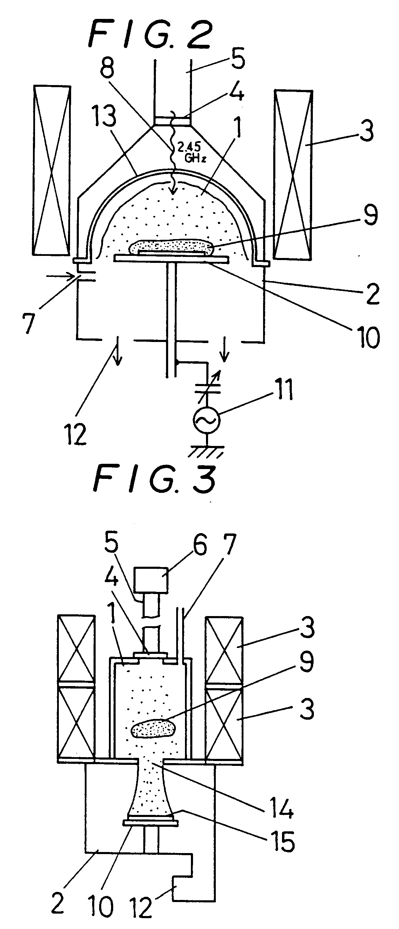

Vorrichtungen der hier interessierenden Art sind derzeit in zwei unterschiedlichen Typen erhältlich. Der eine Typ ist in der japanischen Patentanmeldung 56-155535 beschrieben. Bei der daraus ersichtlichen und in der beiliegenden Fig. 3 dargestellten Mikrowellen-Plasmabearbeitungstechnik, insbesondere Plasmaätzung, sind eine Plasmabildungskammer 1 und eine Spule 3 vorgesehen, die dazu dient, quer durch die Plasmabildungskammer 1 ein Magnetfeld mit einer besonderen Stärke zu erzeugen. Ein Mikrowellengenerator 6 führt über einen Mikrowellenenergie-Wellenleiter 5 und ein Mikrowellen-Einlaßfenster 4 Mikrowellenenergie in die Plasmabildungskammer 1 ein, um zu bewirken, daß in der Plasmabildungskammer 1 das Elektron/Zyklotron-Resonanzphänomen erzeugt wird. Die aus der Elektron/Zyklotron-Resonanz resultierende Energie wirkt mit einer gasförmigen Substanz zusammen, die von einer Gaszuführungsquelle 7 in die Plasmabildungskammer 1 eingeführt wird, wodurch die gasförmige Substanz, wie bei 9 angedeutet ist, in ein Plasma verändert wird. Das Plasma, das innerhalb der Plasmabildungskammer 1 erzeugt worden ist, wird dann als Plasmastrom durch ein Auslaßfenster 14 in eine Substrat-Bearbeitungskammer 2 geleitet, wobei ein divergierender Teil des oben erwähnten Magnetfelds ausgenutzt wird. In der Substrat-Bearbeitungskammer 2 ist ein zu bearbeitendes, z.B. zu ätzendes und auf einem Halter 10 abgelegtes Substrat 15 angeordnet, das durch den Aufprall der ionisierten Gase auf seine Oberfläche dem Ätzprozeß unterworfen wird. In Fig. 3 ist außerdem mit dem Bezugszeichen 12 eine Gasabführungsleitung angedeutet.

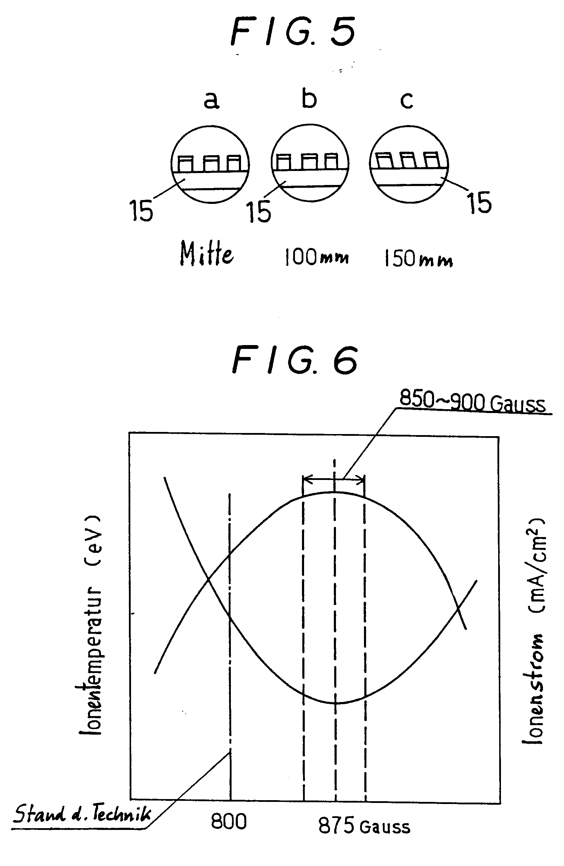

Der andere bekannte Vorrichtungstyp ist in der japanischen Patentanmeldung 60-13423 beschrieben. Die daraus ersichtliche und in der beiliegenden Fig. 4 dargestellte Mikrowellen-Plasmabearbeitungstechnik sieht ebenfalls eine Plasmabildungskammer 1 und ein magnetisches Gradientenfeld entlang dieser Plasmabildungskammer 1 vor. Durch einen Wellenleiter 5 und ein Mikrowellen-Einlaßfenster 4 und eine Quarzglasglocke 13 wird Mikrowellenenergie in die Plasmabildungskammer 1 eingeführt, die innerhalb der Quarzglasglocke 13 angeordnet, aber nicht derart angeordnet und ausgebildet ist, daß sie die an einen Mikrowellen-Hohlraumresonator gestellten Anforderungen erfüllen kann. Innerhalb der Plasmabildungskammer 1, die auch als Substrat-Bearbeitungskammer dient, ist ein Substrathalter 10 angeordnet. Der genannten Vorveröffentlichung kann nur entnommen werden, daß der Substrathalter 10 mit einem Abstand von 300 mm von dem Punkt entfernt angeordnet ist, wo längs der Mittelachse durch die Plasmabildungskammer 1 und in Ausbreitungsrichtung der Mikrowelle die maximale magnetische Dichte erzeugt wird. Andere Hinweise sind der genannten Veröffentlichung nicht zu entnehmen. Aus anderen einschlägigen Publikationen, z.B. "Nikkei Micro Devices" (Seite 61, Juni 1988) und "SEMI Technology Symposium" (Seiten 133 bis 144, 1988), die die Vorrichtung beide in den Einzelheiten beschreiben, ergibt sich jedoch, daß der Substrathalter 10 an einer Stelle angeordnet ist, wo weniger als 800 Gauss erzeugt werden und der zwei Zentimeter von demjenigen Punkt entfernt ist, wo 875 Gauss als Elektron/Zyklotron-Resonanzpunkt erzeugt werden, wenn eine Mikrowellenfrequenz von 2,45 GHz angewendet wird.

Die bekannten, oben beschriebenen Techniken haben gewisse Nachteile, die nachfolgend erläutert werden. Wenn bei dem zuerst erwähnten Typ von Vorrichtungen die geometrische Musterkonfiguration, die durch den Ätzprozeß auf der Oberfläche des Substrats 15 erzeugt wird, das einen Mittelbereich a, einen Randbereich b in einem Abstand von 100 mm vom Zentrum und einen Bereich c in einem Abstand von 150 mm vom Zentrum bzw. in der Nachbarschaft des peripheren Bereichs b entsprechend Fig. 5 enthält, mikroskopisch untersucht wird, dann läßt sich deutlich sehen, daß der Mittelbereich a eine Musterkonfiguartion besitzt, die normal zur Substratoberfläche verläuft, daß jedoch die Neigung besteht, daß diese Konfiguration in Richtung des äußeren Randabschnitts bezüglich der Substratoberfläche eine immer größere Schrägstellung erfährt. Diese Neigung wird um so offensichtlicher, je größer der Durchmesser des zu bearbeitenden Substrats ist. Die Gründe hierfür lassen sich wie folgt bezeichnen:

Das innerhalb der Plasmabildungskammer erzeugte Plasma befindet sich unter dem Einfluß eines divergierenden, längs der Plasmabildungskammer verlaufenden Magnetfelds und bewegt sich als Plasmastrom in Richtung Substratoberfläche. Die geometrische, auf der Substratoberfläche erzeugte Musterkonfiguration hängt weitgehend vom Einfallwinkel ab, unter dem die ionisierten Gase auf die Substratoberfläche aufprallen. Diejenigen Ionen, die zum Ätzprozeß beitragen, treffen unter einem schrägen Winkel bezüglich der Substratoberfläche ein, insbesondere wenn sie auf die äußeren Randbereiche der Substratoberfläche aufprallen. Die äußeren Randbereiche weisen daher Musterformen auf, die nach innen hin geneigt sind. Außerdem ist zu beobachten, daß die ionisierten Gase eine geringe Stromdichte haben, was eine erhöhte Ionenenergie zur Folge haben kann, die zu Defekten unterhalb der Substratoberfläche führen kann.

Weiterhin ist zu beobachten, daß die ionisierten Gase, wenn sie aus dem divergierenden Magnetfeld gezogen werden, über eine lange Strecke wandern müssen, bis sie die Substratoberfläche erreichen. Während dieser Wanderung können die Ionen streuen, und die streuenden Ionen können eine mehr seitliche Ätzung bewirken.

Aus den obigen Erläuterungen ergibt sich, daß mit dem zuerst genannten Typ von Vorrichtungen einige Probleme verbunden sind. Diese Probleme bestehen insbesondere darin, daß das Ätzmuster nicht über die gesamte Substratoberfläche gleichförmig ist, daß die Ionen eine große Energie besitzen und leicht Seitenätzungen auftreten.

Dagegen ergeben sich bei dem zweiten oben genannten Typ von Vorrichtungen die Probleme, daß die Ionenstromdichte zwar im Vergleich zu dem erstgenannten Typ von Vorrichtungen um einen gewissen Betrag erhöht werden kann, daß aber der Ort, wo das zu ätzende Substrat angeordnet ist, vom Elektron/Zyklotron-Resonanzpunkt abweicht. Dies macht es erforderlich, daß die Energie der auf die Substratoberfläche auftreffenden Ionen entsprechend Fig. 6 größer ist und das Substrat keine anisotropen Ätzeigenschaften zeigen kann, selbst wenn eine hohe Vorspannung an das Substrat angelegt wird.

Daneben ist auch bereits eine andere Gattung von Vorrichtungen zur Mikrowellen-Plasmabearbeitung von Substratoberflächen bekannt (EP-A-0 284 436). Die Vorrichtung weist eine das Substrat umgebende Kammer mit einem Mikrowellen-Zuführabschnitt auf, und es sind Mittel zur Erzeugung eines Plasmas innerhalb der Kammer vorgesehen, um das Substrat mit Hilfe dieses Plasmas zu bearbeiten. Dabei wird das Plasma durch den Elektron/Zyklotron-Resonanzeffekt in einer Raumzone erzeugt, die ausreichend klein im Vergleich zur Größe der Kammer ist. Dadurch kann nur eine kleine Zone der Substratoberfläche behandelt werden, d.h. ein gleichförmiges Behandeln der gesamten Substratoberfläche ist nicht möglich.

Der Erfindung liegt die Aufgabe zugrunde, die oben erläuterten Nachteile zu vermeiden, die bei den beiden verschiedenen Typen der die Elektron/Zyklotron-Resonanz ausnützenden Vorrichtungen auftreten, wenn diese beispielsweise zum Ätzen eingesetzt werden. Durch die Erfindung sollen eine hohe Ionenstromdichte, eine niedrige Ionenenergie und anisotrope Ätzeigenschaften erzielt werden.

Zur Lösung dieser Aufgabe wird erfindungsgemäß im wesentlichen vorgeschlagen, das zu bearbeitende, z.B. zu ätzende Substrat an einer genau abgegrenzten Stelle anzuordnen, die dem Elektron/Zyklotron-Resonanzpunkt sehr nahe liegt. Im übrigen sind die erfindungsgemäßen Verfahren und Vorrichtungen zur Lösung der gestellten Aufgabe durch die kennzeichnenden Merkmale der Patentansprüche 1 und 5 gekennzeichnet.

Die gestellte Aufgabe wird somit erfindungsgemäß dadurch gelöst, daß mittels Mikrowellenenergie innerhalb einer Plasmabildungskammer ein elektrisches Feld und außerdem senkrecht zu diesem elektrischen Feld ein Magnetfeld erzeugt wird, wobei der durch das elektrische Feld und das Magnetfeld erzeugte Elektron/Zyklotron-Resonanzeffekt dazu benutzt wird, eine gasförmige Arbeitssubstanz in einen Plasmastrom zu verwandeln, und wobei ein zu bearbeitendes Substrat an einer Stelle angeordnet wird, die dem Elektron/Zyklotron-Resonanzpunkt innerhalb des Plasmas sehr nahe liegt, nämlich dort, wo die Magnetfeldstärke höchstens um etwa ± 3,0 % von der am Resonanzpunkt vorhandenen Magnetfeldstärke abweicht. Es wurde gefunden, daß diese Anordnung es ermöglicht, das Substrat so anzuordnen, daß es sich unter dem Einfluß von magnetischen Kraftlinien befindet, die normal zur Substratoberfläche verlaufen. Daher können die ionisierten Gase das Substrat mit senkrecht zur Substratoberfläche verlaufenden Einfallslinien angreifen, während gleichzeitig die daraus resultierende Ionenstromdichte erhöht werden kann. Das Substrat kann außerdem an einem Ort, wo die niedrigste Ionentemperatur herrscht, und mit stark erhöhter Geschwindigkeit geätzt werden. Das auf diese Weise bearbeitete Substrat kann schließlich anisotrope Eigenschaften und weniger Defekte aufweisen.

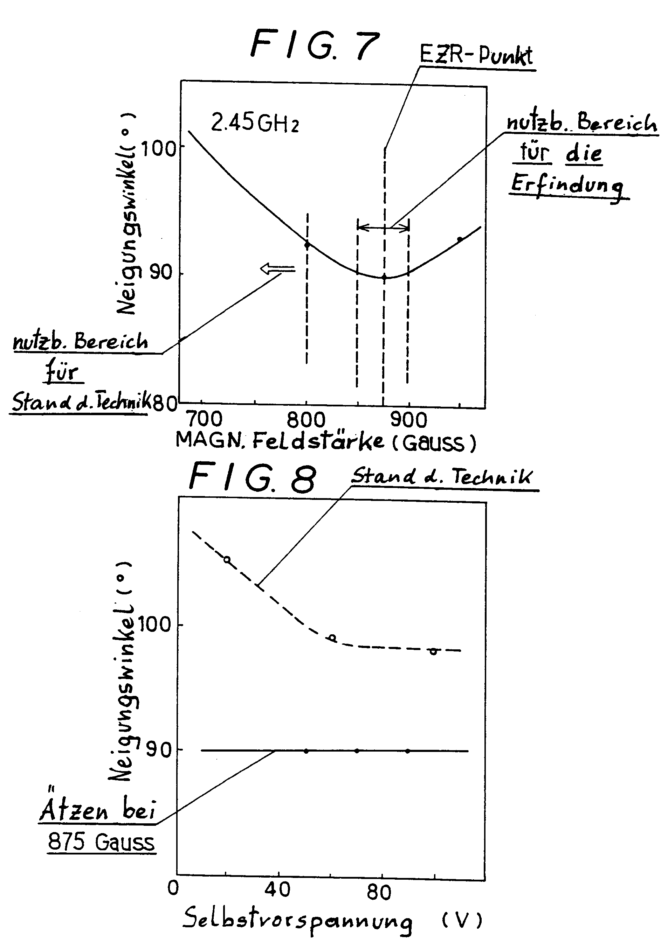

Die mit den erfindungsgemäßen Ätzverfahren bzw. Ätzvorrichtungen erzielten Ergebnisse ergeben sich aus den Fig. 7 und 8. Nach Fig. 7 wird eine Mikrowellenenergie von 2,45 GHz zur Erzeugung einer Elektron/Zyklotron-Resonanz verwendet. Der Resonanzpunkt liegt bei 875 Gauss. Das Ergebnis zeigt, daß der Bereich von 850 bis 900 Gauss zu praktischen Werten führt, die zur Bildung von Ätzmustern mit 90° bezüglich der Substratoberfläche verwendet werden können (Fig. 7). Dieser Wertebereich genügt den Anforderungen, die bei einem im Submikronbereich stattfindenden Ätzprozeß mit 89° bis 91° (90° ± 1°) an die Neigungswinkel gestellt werden. Daher können die in der Praxis gestellten Anforderungen für das Submikronätzen innerhalb des Bereichs von 850 bis 900 Gauss, d.h. 875 bei Gauss ± 3 %, erfüllt werden, so daß dieser Bereich zum Ätzen verwendet werden kann. Fig. 8 zeigt die Ergebnisse, die erhalten werden, wenn eine Hochfrequenz-Vorspannung (z.B. 13,56 MHz) längs des Substrats angelegt wird. Dabei zeigt Fig. 8, wie sich das Ätzmuster in Abhängigkeit von der Selbstvorspannung ändert. Nach Fig. 8 kann das Muster offensichtlich immer, d.h. unabhängig von irgendwelchen Änderungen in der Selbstvorspannung bei 90° gebildet werden. Dabei ist zu beachten, daß die angelegte Hochspannung eine weit höhere Ätzgeschwindigkeit besorgt. Im Gegensatz zu allen Technologien des Standes der Technik erlaubt die Erfindung auch die Anwendung niedrigerer Hochfrequenz-Vorspannungen, die ein anisotropes Ätzen mit hoher Geschwindigkeit ermöglichen.

Weitere vorteilhafte Merkmale der Erfindung ergeben sich aus den Unteransprüchen.

Die Erfindung wird nachfolgend in Verbindung mit der beiliegenden Zeichnung an Ausführungsbeispielen näher erläutert. Es zeigen:
- Fig. 1: schematisch ein erstes erfindungsgemäßes Ausführungsbeispiel einer Mikrowellen-Plasmabearbeitungsvorrichtung von vorn im Vertikalschnitt;
- Fig. 2: eine entsprechende Darstellung einer zweiten erfindungsgemäßen Ausführungsform;
- Fig. 3: in einer ähnlichen Darstellung einen ersten Typ von Vorrichtungen nach dem Stand der Technik;
- Fig. 4: in einer ähnlichen Darstellung einen zweiten Typ von Vorrichtungen nach dem Stand der Technik;
- Fig. 5: schematisch ein bei Anwendung bekannter Ätzverfahren erhaltenes Muster;
- Fig. 6: anhand einer graphischen Darstellung die Änderungen der Temperatur und Stromdichte der Ionen im gebildeten Plasma in Abhängigkeit von der Magnetfeldstärke; und
- Fig. 7 und 8: in weiteren graphischen Darstellungen die bei Anwendung der erfindungsgemäßen Ätzverfahren in den Mustern erzielten Änderungen.

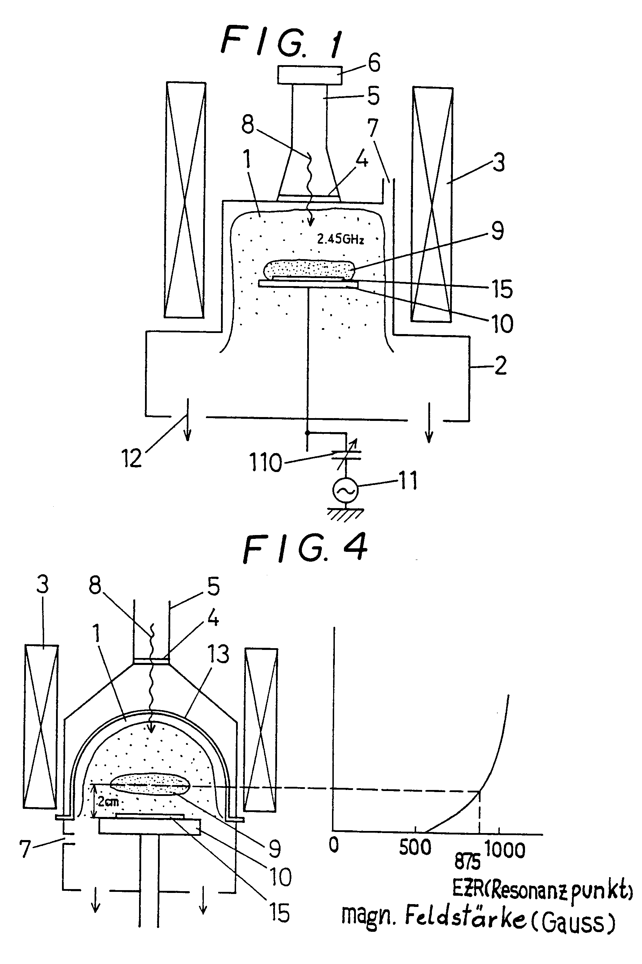

Fig. 1 ist eine schematische Schnittdarstellung eines ersten Ausführungsbeispiels der Erfindung. Die in Fig. 1 dargestellte Vorrichtung enthält ähnliche Teile bezw. Elemente wie die Vorrichtung nach Fig. 3, wobei gleiche Teile mit gleichen Bezugszeichen versehen sind und die einzelnen Teile zur Vermeidung von Wiederholungen nicht erneut beschrieben werden.

Nach Fig. 1 enthält die Vorrichtung eine Plasmabildungskammer 1, in der ein Plasma durch Elektron/Zyklotron-Resonanz erzeugt wird, und eine an die Plasmabildungskammer 1 angrenzende Substrattransferkammer 2. Die Plasmabildungskammer 1 ist so ausgebildet, daß sie die Anforderungen eines Mikrowellen-Hohlraumresonators erfüllt, was es der Mikrowellenenergie ermöglicht, eine höhere elektrische Feldstärke und einen höheren Entladungswirkungsgrad zu erzielen. Die Plasmabildungskammer 1 ist von einer kernlosen Solenoidspule 3 umgeben und weist eine Gaseinlaßöffung 7 auf, durch die eine gasförmige Substanz in die Plasmabildungskammer 1 eingeführt wird, um ein Plasma zu erzeugen. Außerdem weist die Plasmabildungskammer 1 ein Einlaßfenster 4 auf, das aus irgendeinem geeigneten Isoliermaterial, z.B. Quarz oder Sillikaglas, Keramik oder dergleichen hergestellt ist.

Die Mikrowellenenergie wird mittels eines Mikrowellengenerators 6 erzeugt oder über eine geeignete Speiseleitung herangeführt, durch einem Wellenleiter 5 geleitet und dann durch das Einlaßfenster 4 hindurch in die Plasmabildungskammer 1 eingeführt. Die Plasmabildungskammer 1 enthält einen Substrathalter 10, der an einer besonderen Stelle angeordnet ist, nämlich dort, wo eine Magnetfeldstärke von 875 Gauss ± 3,0 % erzeugt werden kann, wenn eine besondere Mikrowellenfrequenz, z.B. 2,45 GHz, angewendet wird.

Ein Substrat 15, das einem Ätzprozeß unterworfen werden soll, wird durch irgendeine geeignete, nicht dargestellte Fördereinrichtung in die Substrattransferkammer 2 transportiert und dort auf dem Substrathalter 10 plaziert. Ein Hochfrequenznetzteil 11 liefert eine Hochfrequenzspannung, die über einen Lade- und Entladekondensator 110 an den Substrathalter 10 angelegt wird.

Fig. 2 ist die Schnittansicht eines zweiten Ausführungsbeispiels der Erfindung.

Die Vorrichtung nach Fig. 2 unterscheidet sich von der nach Fig. 1 dadurch, daß die Plasmabildungskammer 1, in der durch Elektron/Zyklotron-Resonanz ein Plasma erzeugt wird, nicht so angeordnet ist, daß sie die Anforderungen für einen Mikrowellen-Hohlraumresonator erfüllt. Stattdessen ist sie so angeordnet, daß Mikrowellenenergie durch die Vorderseite einer Quarzglocke 13 eingeführt werden kann. Eine Gas-Einlaßöffnung 7 ist an der Substrattransferkammer 2 vorgesehen, da die Gase nicht durch die Plasmabildungskammer 1 eingeführt werden können. Die Plasmabildungskammer 1 enthält einen Substrathalter 10, der an einer besonderen Stelle angeordnet ist, an der eine Magnetfeldstärke von 875 Gauss ± 3,0 % erzeugt wird, und an den eine Hochfrequenzspannung angelegt ist.

Mittels der Mikrowellen-Plasmabearbeitungsvorrichtung nach der vorliegenden Erfindung kann das Substrat am Elektron/Zyklotron-Resonanzpunkt oder an irgendeinem anderen in großer Nähe davon liegenden Ort behandelt, z.B. geätzt werden. Hierdurch wird sichergestellt, daß der anisotrope Ätzprozeß mit höherer Geschwindigkeit durchgeführt werden kann und mit weniger Fehlern verbunden ist.

Es versteht sich, daß die Erfindung nicht auf die beschriebenen Ausführungsbeispiele beschränkt ist, die auf zahlreiche Weise abgewandelt werden können.

## Patentansprüche

1. Verfahren zur Mikrowellen-Plasmabearbeitung, insbesondere Plasmaätzung, einer Substratoberfläche, wobei in einer Plasmabildungskammer (1) unter Benutzung eines elektrischen Feldes und des Elektron/Zyklotron-Resonanzeffektes aus einem Arbeitsgas ein Plasmastrom hergestellt wird, wobei das elektrische Feld durch Mikrowellen erzeugt wird, die aus einem Mikrowellengenerator (6) durch einen Wellenleiter (5) und ein Einlaßfenster (4) eingeführt werden, wobei der Elektron/Zyklotron-Resonanzeffekt durch ein Magnetfeld erzeugt wird, das senkrecht zum elektrischen Feld und normal zur zu ätzenden Substratoberfläche gerichtet ist, und wobei die Substratoberfläche bearbeitet wird, indem sie einer Strahlung dieses Plasmastroms ausgesetzt und während der Bearbeitung im Elektron/Zyklotron-Resonanzpunkt oder an einer von diesem Punkt entfernten Stelle angeordnet wird, an der die Magnetfeldstärke höchstens um etwa ± 3 % von der Magnetfeldstärke am Resonanzpunkt abweicht.

2. Verfahren nach Anspruch 1, dadurch gekennzeichnet, daß während der Bearbeitung der Substratoberfläche eine Hochfrequenz-Vorspannung an das Substrat (15) angelegt wird.

3. Verfahren nach Anspruch 1 oder 2, dadurch gekennzeichnet, daß der Plasmabildungskammer (1) eine Form gegeben wird, die die Anforderungen eines Mikrowellen-Hohlraumresonators erfüllt.

4. Verfahren nach Anspruch 1 oder 2, dadurch gekennzeichnet, daß die Plasmabildungskammer als Quarzglocke (13) ausgebildet wird.

5. Vorrichtung zur Mikrowellen-Plasmabearbeitung, insbesondere Plasmaätzung, einer Substratoberfläche, mit einer Plasmabildungskammer (1), einem Mikrowellen-Zuführmittel (4,5,6,13), das einen Mikrowellengenerator (6) durch einen Wellenleiter (5) und ein Einlaßfenster (4) mit der Plasmabildungskammer verbindet, Mitteln (7) zur Einführung eines Arbeitsgases in die Plasmabildungskammer (1), und Mitteln (3) zur Erzeugung eines Magnetfelds, das senkrecht zu einem durch das Mikrowellen-Zuführmittel (4,5,6,13) in der Plasmabildungskammer (1) erzeugbaren elektrischen Feld und normal zur Substratoberfläche gerichtet ist, dadurch gekennzeichnet, daß innerhalb der Plasmabildungskammer (1) ein Substrathalter (10) angeordnet ist, durch den die Substratoberfläche (15) an einem durch die eingeführten Mikrowellen und das angelegte Magnetfeld erzeugbaren Elektron/Zyklotron-Resonanzpunkt, wo das Magnetfeld eine definierte Stärke besitzt, oder an einer davon um nur so viel beabstandeten Stelle angeordnet wird, daß die Magnetfeldstärke um höchstens etwa ± 3 % von der Magnetfeldstärke am Resonanzpunkt abweicht.

6. Vorrichtung nach Anspruch 5, dadurch gekennzeichnet, daß mit dem Substrathalter (10) ein Mittel (11,110) zum Anlegen einer Hochfrequenz-Vorspannung verbunden ist.

## Claims

1. A method of microwave plasma processing, particularly plasma etching, of a substrate surface, wherein a plasma stream is generated in a plasma formation chamber (1) from a processing gas, by using an electrical field and the electron/cyclotron resonance effect, wherein the electrical field is by microwaves introduced from a microwave generator (6) through a wave guide (5) and an inlet window (4), wherein the electron/cyclotron resonance effect is generated by a magnetic field disposed perpendicular to the electrical field and normal to the substrate surface to be etched, and wherein the substrate surface is processed by exposing it to a radiation of this plasma stream and by arranging it during processing at the electron/cyclotron resonance point or at a location displaced from this point where the magnetic field intensity differs at most by about ± 3 % from the magnetic field intensity at the resonance point.

2. Method of claim 1, characterized by feeding the substrate (15) with a high frequence bias voltage during processing the substrate surface.

3. Method of claim 1 or claim 2, characterized by forming the plasma formation chamber (1) in a way which satisfies the requirements of a microwave cavity resonator.

4. Method of claim 1 or claim 2, characterized by forming the plasma formation chamber like a quartz glass bell jar (13).

5. Device for microwave plasma processing, particularly plasma etching of a substrate surface, comprising a plasma formation chamber (1), microwave feeding means (4,5,6,13) connecting a microwave generator (6) with the plasma formation chamber through a wave guide (5) and an inlet window (4), means (7) for introducing a processing gas into the plasma formation chamber (1), and means (3) for generating a magnetic field directed perpendicular to an electrical field which can be generated by the microwave feeding means (4,5,6,13) in the plasma formation chamber (1), and normal to the substrate surface, characterized by a substrate holder (10) disposed within the plasma formation chamber (1) by which the substrate surface (15) is disposed at an electron/cyclotron resonance point which can be generated by the introduced microwaves and by the imposed magnetic field, and where the magnetic field has a predefined intensity, or at a location distant herefrom only that far, that the magnetic field intensity is differing at most by about. ± 3 % from the magnetic field intensity at the resonance point.

6. Device of claim 5, characterized by means (11,110) coupled to the substrate holder (10) for feeding a high frequency bias voltage.

## Revendications

1. Procédé de traitement par plasma micro-ondes, de gravure par plasma en particulier, d'une surface de substrat, un courant de plasma étant produit à partir d'un gaz de travail dans une chambre de formation de plasma (1), en utilisant un champ électrique et l'effet de résonance gyromagnétique électronique, le champ électrique étant créé par des micro-ondes, introduites par un guide d'ondes (5) et une fenêtre d'entrée (4) à partir d'un générateur de micro-ondes (6), l'effet de résonance gyromagnétique électronique étant produit par un champ magnétique, dirigé à la perpendiculaire du champ électrique et à la normale de la surface du substrat à graver, et la surface du substrat étant traitée en étant exposée à un rayonnement de ce courant de plasma et en étant disposée, pendant le traitement, au point de résonance gyromagnétique électronique ou en un point distant de ce dernier, auquel l'intensité du champ magnétique diffère au maximum de ± 3 % environ de l'intensité du champ magnétique au point de résonance.

2. Procédé suivant la revendication 1, caractérisé en ce qu'une tension de polarisation à haute fréquence est appliquée sur le substrat (15) pendant le traitement de la surface de ce dernier.

3. Procédé suivant l'une des revendications 1 ou 2, caractérisé en ce qu'une forme, remplissant les exigences d'une cavité résonnante à hyperfréquences, est conférée à la chambre de formation de plasma (1).

4. Procédé suivant l'une des revendications 1 ou 2, caractérisé en ce que la chambre de formation de plasma est réalisée sous forme de cloche de quartz (13).

5. Dispositif de traitement par plasma micro-ondes, de gravure par plasma en particulier, d'une surface de substrat, avec une chambre de formation de plasma (1), avec un moyen d'arrivée des micro-ondes (4, 5, 6, 13), qui relie un générateur de micro-ondes (6) à la chambre de formation de plasma par un guide d'ondes (5) et une fenêtre d'entrée (4), avec des moyens (7) d'admission d'un gaz de travail dans la chambre de formation de plasma (1), et avec des moyens (3) pour produire un champ magnétique, dirigé à la perpendiculaire d'un champ électrique, qui peut être créé dans la chambre de formation de plasma (1) par le moyen d'arrivée des micro-ondes (4, 5, 6, 13), et à la normale de la surface du substrat, caractérisé en ce qu'un support de substrat (10) est disposé à l'intérieur de la chambre de formation de plasma (1), la surface du substrat (15) étant placée par ce support en un point de résonance gyromagnétique électronique, qui peut être produit par les micro-ondes introduites et le champ magnétique appliqué, et où le champ magnétique présente une intensité définie, ou en un point uniquement séparé de ce dernier par une distance telle, que l'intensité du champ magnétique diffère au maximum de ± 3 % de l'intensité du champ magnétique au point de résonance.

6. Dispositif suivant la revendication 5, caractérisé en ce qu'un moyen (11, 110) est relié au support de substrat (10) pour appliquer une tension de polarisation à haute fréquence.
